# EUROPEAN PATENT APPLICATION

(11) **EP 4 401 112 A1**
(43) Date of publication of application: **17.07.2024**
(21) Application number: 22867096.4
(22) Date of filing: 26.07.2022
(51) Int. Cl.: H01L 21/20, C08G 73/10, H01L 21/336, H01L 27/12, H01L 29/786

(54) **SEMICONDUCTOR APPARATUS AND METHOD FOR MANUFACTURING SEMICONDUCTOR APPARATUS**

(30) Priority: 08.09.2021 JP 2021146089
(71) Applicant: University of Tsukuba, Ibaraki 305-8577 (JP); TOYOBO CO., LTD., Osaka-shi, Osaka 530-0001 (JP)
(72) Inventor: TOKO, Kaoru, Tsukuba-shi, Ibaraki 305-8577 (JP); NAKAMURA, Muneatsu, Tsuruga-shi, Fukui 914-8550 (JP); MAEDA, Satoshi, Otsu-shi, Shiga 520-0292 (JP)
(74) Representative: Vossius & Partner Patentanwälte Rechtsanwälte mbB
(86) International application number: PCT/JP2022/028747
(87) International publication number: WO 2023/037774

(57) **Abstract**

This semiconductor apparatus has a substrate film and a semiconductor film formed on the substrate film, wherein the substrate film comprises a polyimide obtained by condensation polymerization of an aromatic diamine and an aromatic tetracarboxylic acid anhydride and has a tensile elasticity in the machine direction of 7 GPa or more, and the semiconductor film is polycrystalline and comprises crystal particles having an average particle size of 1 µm or more.

## Description

### TECHNICAL FIELD

The present invention relates to a semiconductor apparatus and a method for manufacturing a semiconductor apparatus.

### BACKGROUND ART

Semiconductor films synthesized on insulators (SiO₂, glass, and plastic) are actively studied as a major constituent element for achieving three-dimensionalization of large-scale integrated circuits (LSIs) and higher performance and lower prices of information terminals and solar cells.

Si is a typical semiconductor and is used in all kinds of electronic devices. Ge and SiGe, which are group IV semiconductors like Si, exhibit high affinity for Si, an existing material, and further have a higher carrier mobility and a lower crystallization temperature than Si, and so are expected as next-generation semiconductor materials.

Patent Document 1 discloses a semiconductor apparatus including a substrate and a semiconductor film formed on one surface of the substrate, in which the semiconductor film is a polycrystalline film formed from crystal grains having an average grain size of 1 µm or more (see particularly claim 1). As a method for manufacturing the semiconductor apparatus, Patent Document 1 also discloses a method for manufacturing a semiconductor apparatus, the method including a first step of forming an amorphous semiconductor film on one surface of a substrate while heating the substrate; and a second step of heating the semiconductor film to promote solid phase growth of the semiconductor film, in which the heating temperature in the first step is adjusted to be 50% or more and less than 100% of the temperature at which crystal nuclei are generated in the semiconductor film (see particularly claim 6). Patent Document 1 discloses that according to the method for manufacturing a semiconductor apparatus, the heating temperature required for solid phase growth is decreased, the semiconductor film of, for example, Ge can be formed without performing treatment at a high temperature of 500°C or more at which the substrate may be damaged, and thus LSI chips, glass exhibiting low heat resistance, plastic, and the like can be widely used as the substrate (see particularly paragraph[0030]).

### PRIOR ART DOCUMENT

### PATENT DOCUMENT

Patent Document 1: JP-A-2018-142672

### SUMMARY OF THE INVENTION

### PROBLEMS TO BE SOLVED BY THE INVENTION

The present inventors have conducted extensive studies on a semiconductor apparatus including a semiconductor film formed of a polycrystalline film formed from crystal grains having an average grain size of 1 um or more. As a result, the present inventors have discovered a new problem that the semiconductor film may peel off from the substrate during manufacturing in a case where plastic is used as the substrate.

The present invention has been made in view of the above-mentioned problems, and an object thereof is to provide a semiconductor apparatus that can prevent a semiconductor film from peeling off from a substrate during manufacturing in a case where the substrate is plastic in a semiconductor apparatus including a semiconductor film formed of a polycrystalline film formed from crystal grains having an average grain size of 1 um or more as well. Another object of the present invention is to provide a method for manufacturing a semiconductor apparatus, which makes it possible to obtain the semiconductor apparatus.

### MEANS FOR SOLVING THE PROBLEMS

The present inventors have conducted extensive studies on semiconductor apparatuses. As a result, the present inventors have discovered that it is possible to provide a semiconductor apparatus that can prevent a semiconductor film from peeling off from a substrate during manufacturing in a case where the substrate is plastic as well by adopting the following configuration in a semiconductor apparatus including a semiconductor film formed of a polycrystalline film formed from crystal grains having an average grain size of 1 µm or more, and thus completed the present invention.

In other words, the present invention provides the following.

A semiconductor apparatus including:
a substrate film; and
a semiconductor film formed on the substrate film,
in which the substrate film is a polyimide film obtained by polycondensation of an aromatic diamine and an aromatic tetracarboxylic anhydride and has a tensile modulus of 7 GPa or more in a machine direction, and
the semiconductor film is a polycrystalline film formed from crystal grains having an average grain size of 1 µm or more.

According to the configuration, a film having a tensile modulus of 7 GPa or more in the machine direction is used as the substrate film. Since the tensile modulus is 7GPa or more in the machine direction, it can be said that the substrate film has little dimensional changes even if exposed to high temperatures. Since a film obtained by polycondensation of an aromatic diamine and an aromatic tetracarboxylic anhydride is used as the substrate film, the substrate film exhibits excellent heat resistance.

As described above, according to the configuration, since a base film is used which exhibits excellent heat resistance and has little dimensional changes even if exposed to high temperatures, the semiconductor film can be prevented from peeling off from the base film even if exposed to high temperatures during manufacturing.

In the configuration, the base film preferably has a coefficient of linear thermal expansion of 5 ppm/°C or less.

When the coefficient of linear thermal expansion of the base film is 5 ppm/°C or less, the difference in the coefficient of linear thermal expansion between the base film and the semiconductor film can be kept small, and the semiconductor film and the base film can easily avoid peeling off from each other when subjected to a process in which heat is applied as well.

The present invention also provides the following.

A method for manufacturing a semiconductor apparatus including a substrate film and a semiconductor film formed on the substrate film, the substrate film being a polyimide film obtained by polycondensation of an aromatic diamine and an aromatic tetracarboxylic anhydride and having a tensile modulus of 7 GPa or more in a machine direction, and the semiconductor film being a polycrystalline film formed from crystal grains having an average grain size of 1 µm or more, the method including:
a first step of forming an amorphous semiconductor film on one surface of the base film while heating the base film; and
a second step of heating the semiconductor film to promote solid phase growth of the semiconductor film,
in which a heating temperature in the first step is adjusted to be 50% or more and less than 1000 of a temperature at which a crystal nucleus is generated in the semiconductor film.

According to the configuration, a film having a tensile modulus of 7 GPa or more in the machine direction is used as the substrate film. Since the tensile modulus is 7GPa or more in the machine direction, it can be said that the substrate film has little dimensional changes even if exposed to high temperatures. Since a film obtained by polycondensation of an aromatic diamine and an aromatic tetracarboxylic anhydride is used as the substrate film, the substrate film exhibits excellent heat resistance.

As described above, according to the configuration, since a base film is used which exhibits excellent heat resistance and has little dimensional changes even if exposed to high temperatures, the semiconductor film can be prevented from peeling off from the base film even if exposed to high temperatures during manufacturing.

In the configuration, a heating temperature in the first step is preferably adjusted so that a density of grains constituting the semiconductor film is 98% or more and less than 102% of a density of grains in a crystal of the same material.

When the heating temperature in the first step is adjusted so that the density of grains constituting the semiconductor film is 98% or more and less than 102% of the density of grains in a crystal of the same material, the temperature can be adjusted to be as high as possible in a range in which crystal nuclei are not generated in the semiconductor film.

In the configuration, the heating temperature in the first step is preferably set to 100°C or more and 150°C or less.

When the heating temperature in the first step is set to 100°C or more and 150°C or less, the temperature can be adjusted to be as high as possible in a range in which crystal nuclei are not generated in the semiconductor film.

In the configuration, the heating temperature in the second step is preferably set to 350°C or more and 800°C or less.

When the heating temperature in the second step is set to 350°C or more and 800°C or less, solid phase growth of the amorphous semiconductor film formed in the first step is promoted, and a polycrystalline semiconductor film (polycrystalline film) can be suitably synthesized.

In the configuration, the base film preferably has a coefficient of linear thermal expansion of 5 ppm/°C or less.

When the coefficient of linear thermal expansion of the base film is 5 ppm/°C or less, the difference in the coefficient of linear thermal expansion between the base film and the semiconductor film can be kept small, and the semiconductor film and the base film can easily avoid peeling off from each other when subjected to a process in which heat is applied as well.

### EFFECT OF THE INVENTION

According to the present invention, it is possible to provide a semiconductor apparatus that can prevent a semiconductor film from peeling off from a base film during manufacturing in a case where the base film is plastic in a semiconductor apparatus including a semiconductor film formed of a polycrystalline film formed from crystal grains having an average grain size of 1 µm or more as well. It is also possible to provide a method for manufacturing a semiconductor apparatus, which makes it possible to obtain the semiconductor apparatus.

### BRIEF DESCRIPTION OF THE DRAWINGS

Fig. 1 is a schematic cross-sectional view of a semiconductor apparatus of the present embodiment.
Fig. 2 is a diagram illustrating the manufacturing process of a semiconductor apparatus of the present embodiment.
Fig. 3 is the results of surface observation of a Ge thin film in Example 1 using a scanning electron microscope (SEM).
Fig. 4 is a grain boundary map of a Ge thin film in Example 1 obtained by electron backscatter diffraction (EBSD) analysis.
Fig. 5 is a graph illustrating the distribution of crystal grain size illustrated in Fig. 4.
Fig. 6 is a graph illustrating the relation between hole mobility and film thickness of a Ge film in Example 1.

### MODE FOR CARRYING OUT THE INVENTION

Hereinafter, embodiments of the present invention will be described in detail with reference to the drawings as appropriate. In the drawings used in the following explanation, in order to make it easier to understand the features of the present embodiment, characteristic parts may be shown enlarged for convenience, and the dimensional ratio and the like of each constituent element may be different from the actual ones. The materials, dimensions, and the like exemplified in the following description are merely examples, and the present invention is not limited thereto and can be implemented with appropriate changes within the scope of achieving the effects of the present invention.

### [Configuration of semiconductor apparatus]

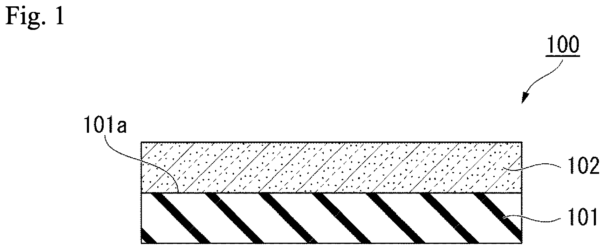

Fig. 1 is a schematic cross-sectional view of a semiconductor apparatus 100 according to an embodiment of the present invention. The semiconductor apparatus 100 includes a base film 101 and a semiconductor film (semiconductor thin film) 102 formed (synthesized) on one surface 101a of the base film 101.

The semiconductor apparatus 100 is preferably a semiconductor apparatus that is flexible (also referred to as a flexible semiconductor apparatus). In this specification, the term "flexible semiconductor apparatus" refers to a semiconductor apparatus that is free of damage such as cracks and chips when visually examined after the semiconductor apparatus was wound around an ABS resin (acrylonitrile-butadiene-styrene copolymer resin) rod having a diameter of 5 mm and then unwound repeatedly 10 times.

The base film 101 has a tensile modulus of 7 GPa or more, preferably 7.5 GPa or more, more preferably 8 GPa or more in the machine direction at 25°C. Since the tensile modulus of the base film 101 is 7GPa or more in the machine direction, it can be said that the base film 101 has little dimensional changes even if exposed to high temperatures. The tensile modulus of the base film 101 in the machine direction is preferably as large as possible, but is preferably 20 GPa or less, more preferably 15 GPa or less from the viewpoint of flexibility. The method for measuring the tensile modulus is as described in Examples.

The tensile strength at break of the base film 101 is preferably 100 MPa or more, more preferably 150 MP or more, still more preferably 200 MPa or more in the machine direction at 25°C. The upper limit of the tensile strength at break is not particularly limited but is practically less than about 1000 MPa. When the tensile strength at break is 100 MPa or more, breaking does not occur during handling, and handling properties are excellent. The method for measuring the tensile strength at break of the base film 101 is as described in Examples.

The tensile elongation at break of the base film 101 is preferably 5% or more, more preferably 10% or more, still more preferably 150 or more in the machine direction at 25°C. When the tensile elongation at break is 5% or more, handling properties are excellent. The upper limit of the tensile elongation at break is not particularly limited, but is practically less than about 80%. The method for measuring the tensile elongation at break of the base film 101 is as described in Examples.

The coefficient of linear thermal expansion (CTE) of the base film 101 is preferably 5 ppm/°C or less in the machine direction.

In this specification, when it is mentioned that the coefficient of linear thermal expansion (CTE) of the base film 101 is 5 ppm/°C or less, this means that CTE (60°C), which is the average value at from 45°C to 75°C, CTE (300°C), which is the average value at from 285°C to 315°C, CTE (390°C), which is the average value at from 375°C to 405°C, and CTE (450°C), which is the average value at from 435°C to 465°C, are all 5 ppm/°C or less.

When CTE is within the above range, the difference in the coefficient of linear expansion between the base film 101 and the semiconductor film 102 can be kept small, and the semiconductor film 102 and the base film 101 can easily avoid peeling off from each other when subjected to a process in which heat is applied as well. Here, CTE is a factor that represents reversible expansion and contraction with respect to the temperature. The method for measuring CTE of the base film 101 is as described in Examples.

The thickness of the base film 101 is not particularly limited, but is preferably 1 µm or more, more preferably 3 µm or more from the viewpoint of handling properties. From the viewpoint of flexibility, the thickness of the base film 101 is preferably 100 µm or less, more preferably 50 µm or less.

The base film 101 is not particularly limited as long as it is a polyimide film obtained by reacting an aromatic diamine and an aromatic tetracarboxylic acid and has a tensile modulus of 7 GPa or more in the machine direction, but preferably, preferable examples thereof include the following combinations of aromatic diamines and aromatic tetracarboxylic acids (anhydrides).
A. A combination of an aromatic tetracarboxylic acid having a pyromellitic acid residue and an aromatic diamine having a benzoxazole structure.
B. A combination of an aromatic diamine having a diaminodiphenyl ether skeleton and an aromatic tetracarboxylic acid having a pyromellitic acid skeleton.
C. A combination of an aromatic diamine having a phenylenediamine skeleton and an aromatic tetracarboxylic acid having a pyromellitic acid skeleton.
D. A combination of one or more of A, B, or C above.

Among these, particularly a combination for producing a polyimide film having an aromatic diamine residue having a benzoxazole structure of A. and a combination in which the aromatic diamine contains at least paraphenylene diamine and/or a diaminodiphenyl ether are preferable.

As the aromatic diamine having a benzoxazole structure, each isomer of amino(aminophenyl)benzoxazole is preferable from the viewpoint of ease of synthesis. Here, "each isomer" is each isomer determined according to the coordination positions of the two amino groups possessed by amino(aminophenyl)benzoxazole. These diamines may be used singly or in combination of two or more kinds thereof.

In the present embodiment, it is preferable to use the aromatic diamine having a benzoxazole structure at 70 mol% or more.

In the present embodiment, the following aromatic diamines may be used without being limited to the items, but preferably, the substrate film is a polyimide film in which one or two or more diamines not having a benzoxazole structure as exemplified below are used in combination as long as the content thereof is less than 30 mol% of the total aromatic diamines. Examples of such diamines include 4,4'-bis(3-aminophenoxy)biphenyl, bis[4-(3-aminophenoxy)phenyl]ketone, bis[4-(3-aminophenoxy)phenyl]sulfide, bis[4-(3-aminophenoxy)phenyl]sulfone, 2,2-bis[4-(3-aminophenoxy)phenyl]propane, 2,2-bis[4-(3-aminophenoxy)phenyl]-1,1,1,3,3,3-hexafluoropropane, m-phenylenediamine, o-phenylenediamine, p-phenylenediamine, m-aminobenzylamine, p-aminobenzylamine,

3,3'-diaminodiphenyl ether, 3,4'-diaminodiphenyl ether, 4,4'-diaminodiphenyl ether, 3,3'-diaminodiphenyl sulfide, 3,3'-diaminodiphenyl sulfoxide, 3,4'-diaminodiphenylsulfoxide, 4,4'-diaminodiphenylsulfoxide, 3,3'-diaminodiphenylsulfone, 3,4'-diaminodiphenylsulfone, 4,4'-diaminodiphenylsulfone, 3,3'-diaminobenzophenone, 3,4'-diaminobenzophenone, 4,4'-diaminobenzophenone, 3,3'-diaminodiphenylmethane, 3,4'-diaminodiphenylmethane, 4,4'-diaminodiphenylmethane, bis[4-(4-aminophenoxy)phenyl]methane, 1,1-bis[4-(4-amino)phenoxy)phenyl]ethane, 1,2-bis[4-(4-aminophenoxy)phenyl]ethane, 1,1-bis[4-(4-aminophenoxy)phenyl]propane, 1,2-bis[4-(4-aminophenoxy) phenyl]propane, 1,3-bis[4-(4-aminophenoxy)phenyl]propane, 2,2-bis[4-(4-aminophenoxy)phenyl]propane,

1,1-bis[4-(4-aminophenoxy)phenyl]butane, 1,3-bis[4-(4-aminophenoxy)phenyl]butane, 1,4-bis[4-(4-aminophenoxy) phenyl]butane, 2,2-bis[4-(4-aminophenoxy)phenyl]butane, 2,3-bis[4-(4-aminophenoxy)phenyl]butane, 2-[4-(4-aminophenoxy)phenyl]-2-[4-(4-aminophenoxy)-3-methylphenyl]propane, 2,2-bis[4-(4-aminophenoxy)-3-methylphenyl]propane, 2-[4-(4-aminophenoxy)phenyl]-2-[4-(4-aminophenoxy)-3,5-dimethylphenyl]propane, 2,2-bis[4-(4-aminophenoxy)-3,5-dimethylphenyl]propane, 2,2-bis[4-(4-aminophenoxy)phenyl]-1,1,1,3,3,3-hexafluoropropane,

1,4-bis(3-aminophenoxy)benzene, 1,3-bis(3-aminophenoxy)benzene, 1,4-bis(4-aminophenoxy)benzene, 4,4'-bis(4-aminophenoxy)biphenyl, bis[4-(4-aminophenoxy)phenyl]ketone, bis[4-(4-aminophenoxy)phenyl]sulfide, bis[4-(4-aminophenoxy)phenyl]sulfoxide, bis[4-(4-aminophenoxy)phenyl]sulfone, bis[4-(3-aminophenoxy)phenyl]ether, bis[4-(4-aminophenoxy)phenyl]ether, 1,3-bis[4-(4-aminophenoxy)benzoyl]benzene, 1,3-bis[4-(3-aminophenoxy)benzoyl]benzene, 1,4-bis[4-(3-aminophenoxy)benzoyl]benzene, 4,4'-bis[(3-aminophenoxy)benzoyl]benzene, 1,1-bis[4-(3-aminophenoxy)phenyl]propane, 1,3-bis[4-(3-aminophenoxy)phenyl]propane, 3,4'-diaminodiphenyl sulfide,

2,2-bis[3-(3-aminophenoxy)phenyl]-1,1,1,3,3,3-hexafluoropropane, bis[4-(3-aminophenoxy)phenyl]methane, 1,1-bis[4-(3-aminophenoxy)phenyl]ethane, 1,2-bis[4-(3-aminophenoxy)phenyl]ethane, bis[4-(3-aminophenoxy)phenyl]sulfoxide, 4,4'-bis[3-(4-aminophenoxy)benzoyl]diphenyl ether, 4,4'-bis[3-(3-aminophenoxy)benzoyl]diphenyl ether, 4,4'-bis[4-(4-amino-α,α-dimethylbenzyl)phenoxy]benzophenone, 4,4'-bis[4-(4-amino-α,α-dimethylbenzyl)phenoxy]diphenylsulfone, bis[4-{4-(4-aminophenoxy)phenoxy}phenyl]sulfone, 1,4-bis[4-(4-aminophenoxy)phenoxy-α,α-dimethylbenzyl]benzene, 1,3-bis[4-(4-aminophenoxy)phenoxy-α,α-dimethylbenzyl]benzene, 1,3-bis[4-(4-amino-6-trifluoromethylphenoxy)-α,α-dimethylbenzyl]benzene, 1,3-bis[4-(4-amino-6-fluorophenoxy)-α,α-dimethylbenzyl]benzene, 1,3-bis[4-(4-amino-6-methylphenoxy)-α,α-dimethylbenzyl]benzene, 1,3-bis[4-(4-amino-6-cyanophenoxy)-α,α-dimethylbenzyl]benzene,

3,3'-diamino-4,4'-diphenoxybenzophenone, 4,4'-diamino-5,5'-diphenoxybenzophenone, 3,4'-diamino-4,5'-diphenoxybenzophenone, 3,3'-diamino-4-phenoxybenzophenone, 4,4'-diamino-5-phenoxybenzophenone, 3,4'-diamino-4-phenoxybenzophenone, 3,4'-diamino-5'-phenoxybenzophenone, 3,3'-diamino-4,4'-dibiphenoxybenzophenone, 4,4'-diamino-5,5'-dibiphenoxybenzophenone, 3,4'-diamino-4,5'-dibiphenoxybenzophenone, 3,3'-diamino-4-biphenoxybenzophenone, 4,4'-diamino-5-biphenoxybenzophenone, 3,4'-diamino-4-biphenoxybenzophenone, 3,4'-diamino-5'-biphenoxybenzophenone, 1,3-bis(3-amino-4-phenoxybenzoyl)benzene, 1,4-bis(3-amino-4-phenoxybenzoyl)benzene, 1,3-bis(4-amino-5-phenoxybenzoyl)benzene, 1,4-bis(4-amino-5-phenoxybenzoyl)benzene, 1,3-bis(3-amino-4-biphenoxybenzoyl)benzene, 1,4-bis(3-amino-4-biphenoxybenzoyl)benzene, 1,3-bis(4-amino-5-biphenoxy)benzoyl)benzene, 1,4-bis(4-amino-5-biphenoxybenzoyl)benzene, and 2,6-bis[4-(4-amino-α,α-dimethylbenzyl)phenoxy]benzonitrile, and aromatic diamines in which some or all of the hydrogen atoms on the aromatic rings in the above-mentioned aromatic diamines are substituted with a halogen atom, an alkyl group or alkoxyl group having 1 to 3 carbon atoms, a cyano group, or a halogenated alkyl group or alkoxyl group having 1 to 3 carbon atoms in which some or all of the hydrogen atoms of an alkyl group or alkoxyl group are substituted with a halogen atom.

The aromatic tetracarboxylic acids used in the present embodiment are, for example, aromatic tetracarboxylic anhydrides. Specifically, the aromatic tetracarboxylic anhydrides include the following. Among these, pyromellitic acid can be preferably used, and is preferably used at 70 mol% or more of the total aromatic tetracarboxylic acids.

These tetracarboxylic dianhydrides may be used singly or in combination of two or more kinds thereof. In the present embodiment, one or two or more non-aromatic tetracarboxylic dianhydrides exemplified below may be used in combination as long as the content thereof is less than 30 mol% of the total tetracarboxylic dianhydrides. Examples of such tetracarboxylic anhydrides include butane-1,2,3,4-tetracarboxylic dianhydride, pentane-1,2,4,5-tetracarboxylic dianhydride, cyclobutanetetracarboxylic dianhydride, cyclopentane-1,2,3,4-tetracarboxylic dianhydride, cyclohexane-1,2,4,5-tetracarboxylic dianhydride, cyclohex-1-ene-2,3,5,6-tetracarboxylic dianhydride, 3-ethylcyclohex-1-ene-3-(1,2),5,6-tetracarboxylic dianhydride, 1-methyl-3-ethylcyclohexane-3-(1,2),5,6-tetracarboxylic dianhydride, 1-methyl-3-ethylcyclohex-1-ene-3-(1,2),5,6-tetracarboxylic dianhydride, 1-ethylcyclohexane-1-(1,2),3,4-tetracarboxylic dianhydride, 1-propylcyclohexane-1-(2,3),3,4-tetracarboxylic dianhydride, 1,3-dipropylcyclohexane-1-(2,3),3-(2,3)-tetracarboxylic dianhydride, and dicyclohexyl-3,4,3',4'-tetracarboxylic dianhydride.

Bicyclo[2.2.1]heptane-2,3,5,6-tetracarboxylic dianhydride, 1-propylcyclohexane-1-(2,3),3,4-tetracarboxylic dianhydride, 1,3-dipropylcyclohexane-1-(2,3),3-(2,3)-tetracarboxylic dianhydride, dicyclohexyl-3,4,3',4'-tetracarboxylic dianhydride, bicyclo[2.2.1]heptane-2,3,5,6-tetracarboxylic dianhydride, bicyclo[2.2.2]octane-2,3,5,6-tetracarboxylic dianhydride, and bicyclo[2.2.2]oct-7-ene-2,3,5,6-tetracarboxylic dianhydride. These tetracarboxylic dianhydrides may be used singly or in combination of two or more kinds thereof.

The solvent used when polyamic acids are obtained by reacting (polycondensation) the aromatic diamines and aromatic tetracarboxylic acids (anhydrides) is not particularly limited as long as it dissolves both the monomers as raw materials and the produced polyamic acids, but polar organic solvents are preferable, and examples thereof include N-methyl-2-pyrrolidone, N-acetyl-2-pyrrolidone, N,N-dimethylformamide, N,N-diethylformamide, N,N-dimethylacetamide, dimethyl sulfoxide, hexamethylphosphoric amide, ethyl cellosolve acetate, diethylene glycol dimethyl ether, sulfolane, and halogenated phenols. These solvents can be used singly or in mixture. The amount of solvent used is only required to be an amount sufficient to dissolve the monomers as raw materials, and a specific amount of solvent used includes an amount so that the mass of monomers in the solution in which the monomers are dissolved is usually 5% to 40% by mass, preferably 10% to 30% by mass.

As the conditions for polymerization reaction to obtain a polyamic acid, conventionally known conditions may be adopted, and specific examples thereof include continuous stirring and/or mixing in an organic solvent in a temperature range of 0°C to 80°C for 10 minutes to 30 hours. If necessary, the polymerization reaction may be divided and the temperature may be raised or lowered. In this case, the order of addition of both monomers is not particularly limited, but it is preferable to add the aromatic tetracarboxylic anhydride to a solution of the aromatic diamine. The mass of polyamic acid in the polyamic acid solution obtained by the polymerization reaction is preferably 5% to 40% by mass, more preferably 10% to 30% by mass, and the viscosity of the solution is preferably 10 to 2000 Pa·s, more preferably 100 to 1000 Pa·s as measured using a Brookfield viscometer (25°C) from the viewpoint of stability of solution sending. The reduced viscosity (ηsp/C) of the polyamic acid in the present embodiment is not particularly limited, but is preferably 3.0 dl/g or more, more preferably 4.0 dl/g or more. Vacuum defoaming during the polymerization reaction is effective in producing a high-quality solution of polyamic acid in an organic solvent. The polymerization may be controlled by adding a small amount of a terminal blocking agent to the aromatic diamine before the polymerization reaction. Examples of the terminal blocking agent include compounds having a carbon-carbon double bond, such as maleic anhydride. In a case of using maleic anhydride, the amount of maleic anhydride used is preferably 0.001 to 1.0 mole per 1 mole of aromatic diamine.

The obtained polyamic acid solution is cast onto an endless support and drying, desolventizing and the like are performed to obtain a self-supporting polyimide precursor film (hereinafter also referred to as a green film) that has not been completely imidized, and one end, this film is wound up or subsequently subjected to treatment at a high temperature and the like to conduct imidization, whereby a polyimide film is formed. As the imidization method by high-temperature treatment, conventionally known imidization reactions can be used as appropriate. Examples thereof include a method (so-called thermal ring closure method) in which a polyamic acid solution not containing a catalyst for ring closure or a dehydrating agent is subjected to heat treatment to advance the imidization reaction, and a chemical ring closure method in which a catalyst for ring closure and a dehydrating agent are contained in a polyamic acid solution and the imidization reaction is conducted by the action of the catalyst for ring closure and dehydrating agent.

In the chemical ring closure method, the imidization reaction of the polyamic acid solution can be partly conducted to form a self-supporting precursor composite and then imidization can be completely conducted by heating. In this case, the conditions for partly conducting the imidization reaction are preferably heat treatment at 100°C to 200°C for 3 to 20 minutes, and the conditions for completely conducting the imidization reaction are preferably heat treatment at 200°C to 400°C for 3 to 20 minutes. The timing of adding the catalyst for ring closure to the polyamic acid solution is not particularly limited, and the catalyst for ring closure may be added in advance before the polymerization reaction to obtain the polyamic acid is conducted. Specific examples of the catalyst for ring closure include aliphatic tertiary amines such as trimethylamine and triethylamine and heterocyclic tertiary amines such as isoquinoline, pyridine and betapicoline, and among these, at least one amine selected from heterocyclic tertiary amines is preferable. The amount of the catalyst for ring closure used per 1 mole of polyamic acid is not particularly limited, but is preferably 0.5 to 8 moles. The timing of adding the dehydrating agent to the polyamic acid solution is also not particularly limited, and the dehydrating agent may be added in advance before the polymerization reaction to obtain the polyamic acid is conducted. Specific examples of the dehydrating agent include aliphatic carboxylic anhydrides such as acetic anhydride, propionic anhydride, and butyric anhydride and aromatic carboxylic anhydrides such as benzoic anhydride, and among these, acetic anhydride, benzoic anhydride, or a mixture thereof is preferable. The amount of the dehydrating agent used per 1 mole of polyamic acid is not particularly limited, but is preferably 0.1 to 4 moles. In a case of using a dehydrating agent, a gelation retarder such as acetylacetone may be used in combination.

As a specific method for imidization, the above-mentioned imidization reaction and imidization treatment can be used as appropriate, but preferably, it is preferable to perform high-temperature imidization treatment at a highest treatment temperature of 460°C or more and less than 500°C for a time of 3 minutes or more and 30 minutes or less. The thickness of the polyimide film and polyimide benzoxazole film is not particularly limited, but is usually 3 to 200 um, preferably 10 to 150 um when it is considered to use the films as a substrate film for film solar cells. This thickness can be easily controlled by the amount of polyamic acid solution applied to the support and the concentration of the polyamic acid solution. The polyimide film of the present embodiment is usually a cast film, but may be uniaxially or biaxially stretched. Here, the "cast film" refers to a film obtained without intentionally applying an external mechanical force in the direction in which the surface of the film expands by tenter stretching, roll stretching, inflation stretching, and the like.

The semiconductor film 102 is a polycrystalline film formed from any material that can be formed into a thin film, for example, crystal grains, such as Ge, SiGe, Si, GeSn, SiC, GaAs, InP, GaN, ZnSe, CdS, or ZnO, treated to have a large grain size. The average grain size of the crystal grains may be 1 µm or more, and is preferably 5 um or more and 30 um or less, more preferably about 30 µm.

The thickness of the semiconductor film 102 is preferably 50 nm or more, more preferably 50 nm or more and 5000 nm or less.

### [Method for manufacturing semiconductor apparatus]

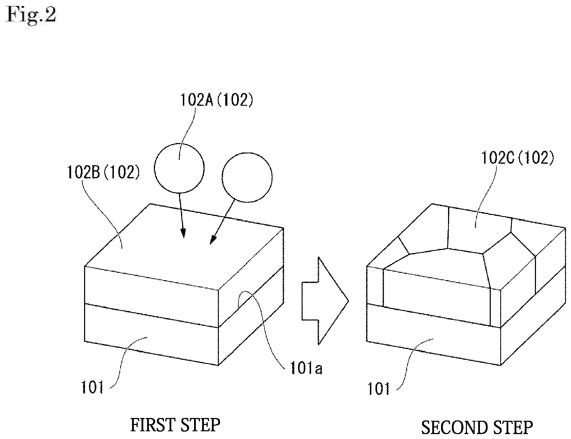

Two main steps for manufacturing a semiconductor apparatus 100 will be explained with reference to Fig. 2.

### (First step)

While a base film 101 is heated, grains 102A, such as Ge, SiGe, Si, GeSn, SiC, GaAs, InP, GaN, ZnSe, CdS, or ZnO, are deposited on one surface 101 of the base film to form an amorphous semiconductor film 102B (left side in Fig. 2).

The heating method and deposition method are not particularly limited, and general methods (molecular beam deposition method, CVD method, sputtering method, and the like) can be used. In a case of using the molecular beam deposition method, a molecular beam of the grains 102A is generated in a high vacuum, and one surface 101a of the base film being heated is irradiated with this molecular beam to deposit the grains 102A, whereby the amorphous film 102B is formed. This method is excellent in that the temperature for film formation can be set low.

The heating temperature in the first step is adjusted so that the amorphous film 102B to be formed is in a state in which the particle number density is as close to that of a crystal as possible and crystal nuclei are not generated. In other words, the heating temperature is adjusted to be as high as possible in a range in which crystal nuclei are not generated in the semiconductor film 102B. The heating temperature in the first step is preferably adjusted so that the density of grains constituting the semiconductor film is 98% or more and less than 102% of the density of grains in a crystal of the same material.

Specifically, the heating temperature may be adjusted to be 30% or more and less than 100%, more preferably 50% or more and less than 100% of the temperature at which crystal nuclei are generated in the semiconductor film 102B. More specifically, the heating temperature is approximately 100°C or more and 700°C or less. This temperature is adjusted depending on the material and thickness of the semiconductor film 102 to be formed. For example, in a case of forming a 100 nm thick semiconductor film 102 formed from Ge, the temperature is set to 100°C to 150°C. In a case of forming a 100 nm thick semiconductor film 102 formed from SiGe or Si, the temperature is set to 100°C to 650°C or 500°C to 650°C.

### (Second step)

Heat treatment (in any atmosphere) is performed to promote solid phase growth of the amorphous semiconductor film 102B formed in the first step, whereby a polycrystalline semiconductor film (polycrystalline film) 102C is synthesized (right side of Fig. 2). In the second step, the heating temperature is preferably set to 350°C or more and 800°C or less, and the heating time is preferably set to 0.1 hour or more and 300 hours or less.

By adjusting the heating temperature in the first step as described above, the semiconductor film 102C to be formed becomes a polycrystalline film formed from grains having a large grain size of 1 um or more.

The semiconductor apparatus 100 obtained through the first step and the second step includes the polycrystalline semiconductor film 102C obtained by forming the amorphous film 102B having a density close to that of a crystal in a range in which crystal nuclei are not generated and subjecting this amorphous film 102B to solid phase growth in the manufacturing process. This semiconductor film 102C is a polycrystalline film formed from crystal grains treated to have a large grain size of 1 um or more, and it is thus possible to achieve a higher carrier mobility than in the past when the semiconductor apparatus 100 is operated as a device. For example, in a 100 nm thick semiconductor film formed from Ge, the hole mobility can be improved to 290 cm²/V·s. For example, in a 300 nm thick semiconductor film formed from Ge, the hole mobility can be improved to 320 cm²/V·s.

In a case where the grain size of the crystals constituting the semiconductor film 102 is smaller than 1 um, scattering of carriers due to grain boundaries becomes significant, and it is thus not possible to obtain a mobility equivalent to that in the present embodiment.

Here, the substrate film 101 is a film obtained by polycondensation of an aromatic diamine and an aromatic tetracarboxylic anhydride and has a tensile modulus of 7 GPa or more in the machine direction. Since the tensile modulus of the substrate film 101 is 7GPa or more in the machine direction, it can be said that the substrate film 101 has little dimensional changes even if exposed to high temperatures. Since a film obtained by polycondensation of an aromatic diamine and an aromatic tetracarboxylic anhydride is used as the substrate film 101, the substrate film 101 exhibits excellent heat resistance.

As described above, in the present embodiment, since the base film 101 is used which exhibits excellent heat resistance and has little dimensional changes even if exposed to high temperatures, the semiconductor film 102C can be prevented from peeling off from the base film 101 even if exposed to high temperatures during manufacturing (first step, second step, and the like).

As described above, the semiconductor apparatus 100 according to the present embodiment includes the semiconductor film 102C obtained by forming the amorphous film 102B having a density close to that of a crystal in a range in which crystal nuclei are not generated and subjecting this amorphous film 102B to solid phase growth in the manufacturing process. This semiconductor film 102C is a polycrystalline film formed from crystal grains treated to have a large grain size of 1 µm or more, and it is thus possible to achieve a higher carrier mobility than in the past.

As the base film 101, since a film is used which is obtained by polycondensation of an aromatic diamine and an aromatic tetracarboxylic anhydride and has a tensile modulus of 7 GPa or more in the machine direction, the semiconductor film 102C can be prevented from peeling off from the base film 101 even if exposed to high temperatures during manufacturing (first step, second step, and the like).

In the case of the semiconductor film 102C in the present embodiment, the heating temperature required for solid phase growth is decreased. For example, when Ge is used, the semiconductor film 102C can be formed without performing treatment at a high temperature of 500°C or more at which the base film 101 may be damaged.

The semiconductor apparatus and the method for manufacturing a semiconductor apparatus according to the present embodiment can be widely utilized for "development of high-speed, lightweight and flexible portable information terminals", "three-dimensionalization and multi-functionalization of LSI", "development of multi-junction solar cells that achieve both high efficiency and low cost", and the like.

### EXAMPLES

Hereinafter, the present invention will be described with reference to Examples, but the present invention is not limited thereto. The evaluation methods of physical properties in the following Examples are as follows.

### 1. Film thickness of polyimide film

The film thickness was measured using a micrometer (Millitron 1254D manufactured by Feinpruf GmbH).

### 2. Tensile strength at break, tensile elongation at break, and tensile modulus of polyimide film (25°C)

The dried film was cut into a strip of 100 mm long and 10 mm wide in the machine direction (MD direction) to use as a test piece, the test piece was seasoned in an environment of 25°C and 60% RH for 24 hours, and then the tensile strength at break, tensile elongation at break, and tensile modulus were measured in the same environment using a tensile testing machine (Autograph (trade name), model name AG-5000A manufactured by Shimadzu Corporation) under conditions of a tensile speed of 50 mm/min and a distance between chucks of 40 mm.

### 3. Coefficient of linear thermal expansion (CTE) of polyimide film

The rate of dimensional change of the polyimide film to be measured in the MD direction was measured under the following conditions, the rate of dimensional change/temperature at 15°C intervals, such as 30°C to 45°C, 45°C to 60°C, and the like, was measured, this measurement was performed up to 465°C, and the average value of the measured values at from 45°C to 75°C was calculated as CTE (60°C), the average value of the measured values at from 285°C to 315°C was calculated as CTE (300°C), the average value of the measured values at from 375°C to 405°C was calculated as CTE (390°C), and the average value of the measured values at from 435°C to 465°C was calculated as CTE (450°C).
Instrument name; TMA4000S manufactured by MAC Science Corporation
Length of sample; 20 mm
Width of sample; 2 mm
Start temperature in temperature increase; 25°C
End temperature in temperature increase; 480°C
Rate of temperature increase; 5°C/min
Atmosphere; Argon

### <Fabrication of polyimide film A>

Into an autoclave, 3600 parts by mass of parachlorophenol was put, 93 parts by mass of diaminodiphenyl ether (ODA) and 294 parts by mass of 3,3',4,4'-biphenyltetracarboxylic dianhydride (BPDA) were added, and stirring and mixing was performed. Next, the inside of the autoclave was purged with nitrogen gas, 45 parts by mass of paraphenylenediamine (PDA) was quickly added, and the reaction was conducted in a tightly closed state at 180°C for 12 hours to obtain a dope in which the imidization reaction had been completed. The obtained dope was cooled to 80°C, filtered, then allowed to pass through a deaerator, applied onto a stainless steel endless belt using a die coater, and dried at 150°C to 160°C to form a self-supporting film. The film was peeled off from the endless belt, both ends of the self-supporting film were pricked with pins, and the film was allowed to continuously pass through a pin tenter at a fixed length in the transverse direction. The film was heated according to a profile in which the temperature was increased sequentially with heating at 200°C for 5 minutes, 300°C for 5 minutes, 400°C for 5 minutes, and 450°C for 5 minutes. Finally, both ends of the film were peeled off from the pins, and the pin pricked portions were removed using a slit to obtain a brown polyimide film A having a width of 500 mm, a length of 450 m, and a thickness of 38 um. The properties of the polyimide film A are presented in Table 1.

### <Fabrication of polyimide film B>

Into an autoclave, 3000 parts by mass of N-methylpyrrolidone, 186 parts by mass of diaminodiphenyl ether (ODA), and 218 parts by mass of pyromellitic dianhydride (PMDA) were put. Next, the inside of the autoclave was purged with nitrogen gas, the reaction was conducted in a tightly closed state at 60°C for 12 hours, and then cooling to 25°C was performed to obtain a polyamic acid solution. The obtained polyamic acid solution was filtered, then allowed to pass through a deaerator, applied to the smooth surface of a polyester film (COSMOSHINE A-4100 manufactured by TOYOBO CO., LTD.) having a width of 750 mm and a thickness of 188 µm using a die coater, and dried at 110°C to 125°C to form a dry coating film on the polyester film, and the dry coating film was wound up together with the polyester film to obtain a roll.

Next, the roll was set in the unwinding section of a pin tenter having an unwinding section and a winding section, the dry coating film was unwound together with the polyester film, and the dry coating film was continuously peeled off from the polyester film to obtain a self-supporting film. Both ends of the self-supporting film were pricked with pins, and the film was allowed to continuously pass through a pin tenter at a fixed length in the transverse direction, heated according to a profile in which the temperature was increased sequentially with heating at 200°C for 5 minutes, 300°C for 5 minutes, and 400°C for 10 minutes, and cooled. Finally, both ends of the film were peeled off from the pins, and the pin pricked portions were removed using a slit to obtain a brown polyimide film B having a width of 500 mm, a length of 320 m, and a thickness of 25 um. The properties of the polyimide film B are presented in Table 1.

### <Fabrication of polyimide film C>

Into an autoclave, 4000 parts by mass of N,N-dimethylacetamide and 225 parts by mass of 5-amino-2-(p-aminophenyl)benzoxazole (DAMBO) were put, and stirred to be dissolved, then 218 parts by mass of pyromellitic dianhydride (PMDA) was added, and stirring was performed at a reaction temperature of 25°C for 48 hours to obtain a pale yellow and viscous polyamic acid solution. The obtained polyamic acid solution was filtered, then allowed to pass through a deaerator, applied to the smooth surface of a polyester film (COSMOSHINE A-4100 manufactured by TOYOBO CO., LTD.) having a width of 750 mm and a thickness of 188 um using a die coater, and dried at 110°C to 120°C to form a dry coating film on the polyester film, and the dry coating film was wound up together with the polyester film to obtain a roll.

Next, the roll was set in the unwinding section of a pin tenter having an unwinding section and a winding section, the dry coating film was unwound together with the polyester film, and the dry coating film was continuously peeled off from the polyester film to obtain a self-supporting film. Both ends of the self-supporting film were pricked with pins, and the film was allowed to continuously pass through a pin tenter at a fixed length in the transverse direction, heated according to a profile in which the temperature was increased sequentially with heating at 200°C for 3 minutes, 225°C for 3 minutes, and 475°C for 6 minutes, and cooled. Finally, both ends of the film were peeled off from the pins, and the pin pricked portions were removed using a slit to obtain a brown polyimide film C having a width of 500 mm, a length of 320 m, and a thickness of 18 µm. The properties of the polyimide film C are presented in Table 1.

**[Table 1]**

| Polyimide film | | A | B | C |
|---|---|---|---|---|
| Film properties | Composition: Acid component | BPDA | PMDA | PMDA |
| | Composition: Diamine component | PDA/ODA | ODA | DAMBO |
| | Thickness [um] | 38 | 25 | 18 |
| | Appearance | Brown transparent | Yellow-brown transparent | Yellow-brown transparent |
| | Tensile strength at break [Mpa] | 370 | 420 | 480 |
| | Tensile elongation at break [%] | 55 | 74 | 38 |
| | Tensile modulus (25°C) [GPa] | 5.8 | 4.2 | 7.2 |
| | CTE (60°C) [ppm/K] | 15 | 16 | 2.5 |
| | CTE (300°C) [ppm/K] | 26 | 22 | 2.1 |
| | CTE (390°C) [ppm/K] | 38 | 31 | 1.9 |
| | CTE (450°C) [ppm/K] | 32 | 28 | 2.4 |

### <Example 1>

### (Fabrication 1 of germanium thin film)

By the molecular beam deposition method, germanium (Ge) grains were deposited on the polyimide film C obtained above in a state in which the substrate temperature was set to 125°C to form (vapor-deposition) a Ge thin film having a thickness of 100 nm (first step). The film formation rate was 1 nm/min.

After that, the sample that underwent the first step was introduced into an electric furnace in a nitrogen atmosphere, heat treatment was performed on the Ge thin film formed in the first step at 450°C for 5 hours to promote solid phase growth (second step).

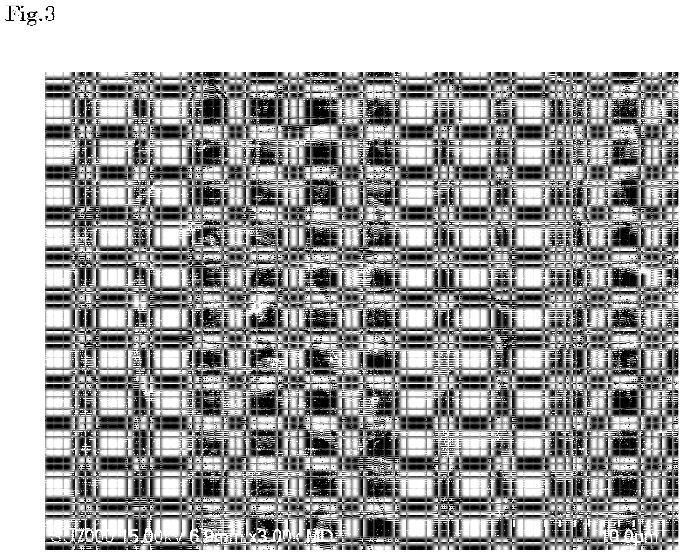

The surface of the 100 nm thick Ge thin film obtained through the second step was observed using a scanning electron microscope (SEM), and the results are illustrated in Fig. 3. From the SEM image, only contrast of the crystals is observed, and peeling off or cracking of the Ge thin film is not observed.

The grain size of constituent grains of the 100 nm thick polycrystalline Ge film obtained through the second step was evaluated by the electron backscatter diffraction (EBSD) method.

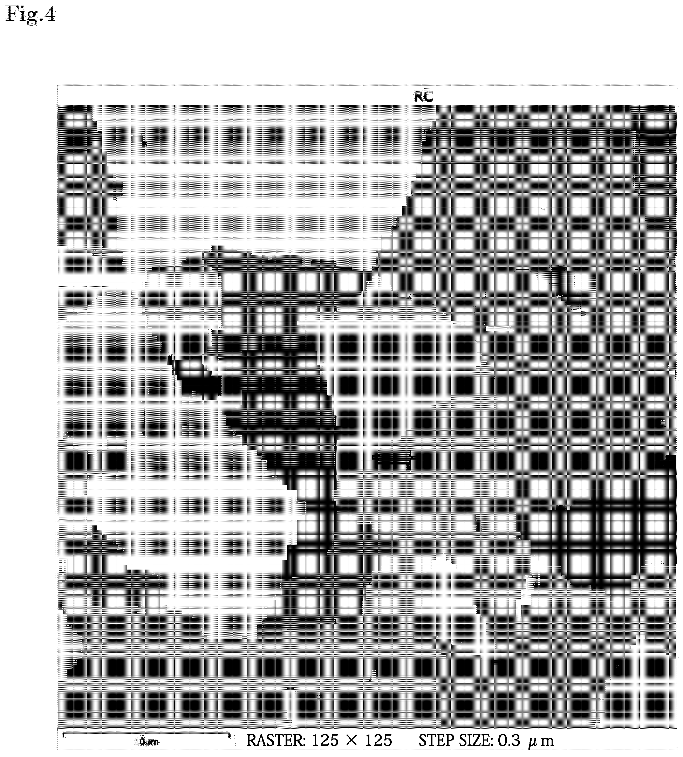

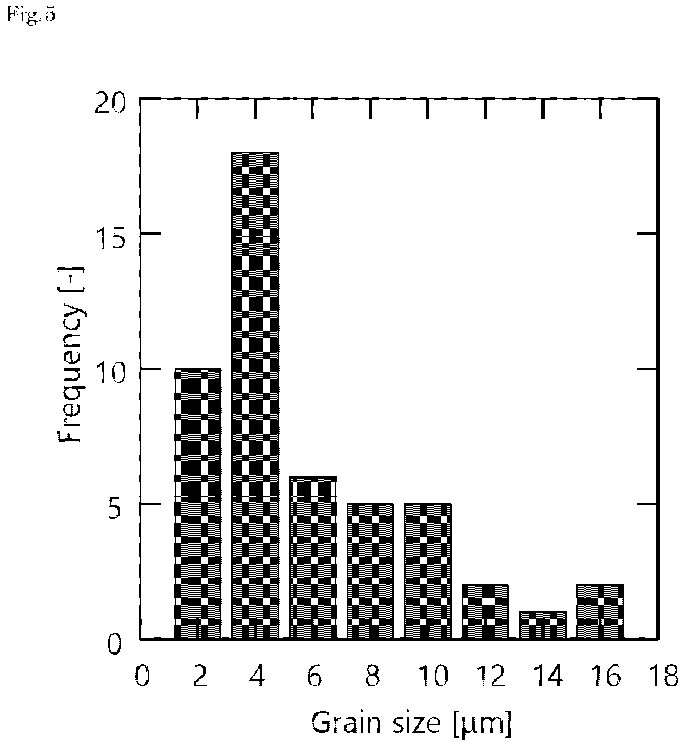

The grain boundary map obtained by the EBSD analysis is illustrated in Fig. 4, and the crystal grain size distribution is illustrated in Fig. 5. It can be seen that the polycrystalline Ge film is composed of crystal grains of 1 µm or more. The average crystal grain size was calculated to be 5.6 µm.

The electrical properties of the polycrystalline Ge film obtained through the second step were evaluated by the van der Pauw method.

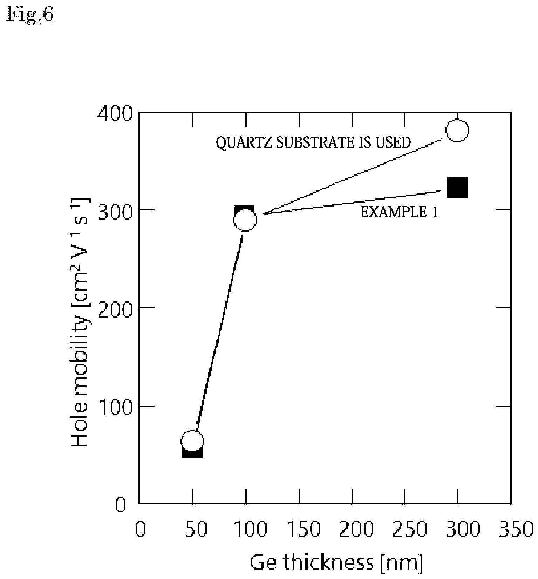

Fig. 6 is a graph illustrating the relation between hole mobility and film thickness of the polycrystalline Ge film. It can be seen that the hole mobility obtained is comparable to that of a polycrystalline Ge film formed on a quartz glass substrate through the same process. A high hole mobility (300 cm²/V·s) is obtained when the Ge film thickness is 100 nm or more.

### <Example 2>

### (Fabrication 2 of germanium thin film)

In the first step, the same operation as in Example 1 was performed except that the thickness of the thin film of germanium (Ge) grains was changed to 50 nm. The surface of the 50 nm thick Ge thin film obtained through the second step was observed using a scanning electron microscope (SEM). From the SEM image, only contrast of the crystals is observed, and peeling off or cracking of the Ge thin film is not observed.

### <Example 3>

### (Fabrication 3 of germanium thin film)

In the first step, the same operation as in Example 1 was performed except that the thickness of the thin film of germanium (Ge) grains was changed to 300 nm. The surface of the 300 nm thick Ge thin film obtained through the second step was observed using a scanning electron microscope (SEM). From the SEM image, only contrast of the crystals is observed, and peeling off or cracking of the Ge thin film is not observed.

### (Comparative Example 1)

A germanium thin film was fabricated using the polyimide film A in the same manner as in Example 1.

Germanium (Ge) grains were deposited in the same manner as in Example 1 in a state in which the substrate temperature Td was set in the range of 50°C to 200°C to form (vapor-deposition) a Ge thin film having a thickness of 100 nm (first step). The film formation rate was 1 nm/min, the same as in Example 1, and the film formation time was also the same, 100 minutes.

Next, as a second step, the Ge thin film formed in the first step was introduced into an electric furnace in a nitrogen atmosphere, and subjected to heat treatment at 375°C for 140 hours, 400°C for 60 hours, and 450°C for 5 hours for the purpose of promoting solid phase growth. However, in all samples, significant warping, which was considered to be due to shrinkage of the substrate, occurred and the germanium thin film peeled off from the substrate film in the samples subjected to heat treatment at 400°C and 450°C. For this reason, it was not possible to measure the crystal grain system and mobility of the germanium thin films.

### (Comparative Example 2)

A germanium thin film was fabricated using the polyimide film B in the same manner as in Example 1.

Germanium (Ge) grains were deposited in the same manner as in Example 1 in a state in which the substrate temperature Td was set in the range of 50°C to 200°C to form (vapor-deposition) a Ge thin film having a thickness of 100 nm (first step). The film formation rate was 1 nm/min, the same as in Example 1, and the film formation time was also the same, 100 minutes.

Next, as a second step, the Ge thin film formed in the first step was introduced into an electric furnace in a nitrogen atmosphere, and subjected to heat treatment at 375°C for 140 hours, 400°C for 60 hours, and 450°C for 5 hours for the purpose of promoting solid phase growth.

As a result, in the case of heat treatment at 375°C for 140 hours, crystal growth was confirmed and the hole mobility was 150 cm²/V·s.

Expecting improvement in properties, the observation was also performed in the heat treatment at 400°C and the heat treatment at 450°C, but regarding the product subjected to heat treatment at 400°C, wrinkling, which was considered to be caused by thermal shrinkage of the film, occurred, and mobility measurement could not be performed. Furthermore, in the product subjected to heat treatment at 450°C, the film substrate deteriorated significantly, the product was in an extremely brittle state, it was difficult to pick the product up with tweezers when taken out of the electric furnace, and the evaluation of this product also could not be performed.

### DESCRIPTION OF REFERENCE SIGNS

- 100: Semiconductor apparatus
- 101: Base film
- 101a: One surface of Base
- 102, 102A: Grains
- 102B, 102C: Semiconductor film

## Claims

1. A semiconductor apparatus comprising:
a substrate film; and
a semiconductor film formed on the substrate film,
wherein the substrate film is a polyimide film obtained by polycondensation of an aromatic diamine and an aromatic tetracarboxylic anhydride and has a tensile modulus of 7 GPa or more in a machine direction, and
the semiconductor film is a polycrystalline film formed from crystal grains having an average grain size of 1 µm or more.

2. The semiconductor apparatus according to claim 1, wherein the base film has a coefficient of linear thermal expansion of 5 ppm/°C or less.

3. A method for manufacturing a semiconductor apparatus including a substrate film and a semiconductor film formed on the substrate film, the substrate film being a polyimide film obtained by polycondensation of an aromatic diamine and an aromatic tetracarboxylic anhydride and having a tensile modulus of 7 GPa or more in a machine direction, and the semiconductor film being a polycrystalline film formed from crystal grains having an average grain size of 1 µm or more, the method comprising:
a first step of forming an amorphous semiconductor film on one surface of the base film while heating the base film; and
a second step of heating the semiconductor film to promote solid phase growth of the semiconductor film,
wherein a heating temperature in the first step is adjusted to be 50% or more and less than 1000 of a temperature at which a crystal nucleus is generated in the semiconductor film.

4. The method for manufacturing a semiconductor apparatus according to claim 3, wherein a heating temperature in the first step is adjusted so that a density of grains constituting the semiconductor film is 98% or more and less than 102% of a density of grains in a crystal of the same material.

5. The method for manufacturing a semiconductor apparatus according to claim 3 or 4, wherein a heating temperature in the first step is set to 100°C or more and 150°C or less.

6. The method of manufacturing a semiconductor apparatus according to any one of claims 3 to 5, wherein a heating temperature in the second step is set to 350°C or more and 800°C or less.

7. The method of manufacturing a semiconductor apparatus according to any one of claims 3 to 6, wherein the base film has a coefficient of linear thermal expansion of 5 ppm/°C or less.
